(19) Europäisches Patentamt

European Patent Office

Office européen des brevets

(11) Veröffentlichungsnummer: **0 209 656 B1**

(12) **EUROPÄISCHE PATENTSCHRIFT**

(45) Veröffentlichungstag der Patentschrift: **30.12.92**

(21) Anmeldenummer: **86106387.3**

(22) Anmeldetag: **10.05.86**

(51) Int. Cl.⁵: **G01R 29/02**, G01P 3/489

(54) **Verfahren und Vorrichtung zur Auswertung einer Information in Frequenz und Pulsbreite enthaltenden Impulsfolge.**

(30) Priorität: **01.06.85 DE 3519716**

(43) Veröffentlichungstag der Anmeldung:
**28.01.87 Patentblatt 87/05**

(45) Bekanntmachung des Hinweises auf die
Patenterteilung:
**30.12.92 Patentblatt 92/53**

(84) Benannte Vertragsstaaten:
**DE FR SE**

(56) Entgegenhaltungen:
**DE-A- 3 207 556**
**DE-A- 3 340 455**
**DE-C- 1 281 572**

(73) Patentinhaber: **ROBERT BOSCH GMBH**
**Postfach 30 02 20**
**W-7000 Stuttgart 30(DE)**

(72) Erfinder: **Bauer, Jürgen**
**Torfstrasse 15**
**W-7250 Leonberg(DE)**
Erfinder: **Bräuninger, Jürgen,**
**Dr.rer.nat.Dipl.-Math.**
**Kaiserslauterer Strasse 60**
**W-7000 Stuttgart 31(DE)**
Erfinder: **Sieber, Albrecht, Dipl.-Ing.**
**Hans-Thoma-Strasse 11**
**W-7140 Ludwigsburg(DE)**

EP 0 209 656 B1

## Beschreibung

Stand der Technik

Die Erfindung betrift ein Verfahren und eine Vorrichtung zur Auswertung einer Periodendauer und einer Impulsbreitenzeit einer Impulsfolge mit positiven und negativen Flanken.

Bei der elektronischen Regelung des Betriebs von Brennkraftmaschinen erzeugt ein zentrales Steuergerät die erforderlichen Stellsignale und führt sie den entsprechenden Stellwerken zu. Der Einsatz elektronischer Komponenten in Verbindung mit einer solchen elektronischen Regelung (EDC) erfordert unter anderem die Auswertung von Impulsfolgen, die eine Information in ihrer Frequenz und eine Information in ihrer Pulsbreite enthalten. So erfolgt beispielsweise die Auswertung des Signals eines Fahrgeschwindigkeitsgebers durch einen Mikroprozessor zum Zwecke einer Fahrgeschwindigkeitsbegrenzung oder einer Fahrgeschwindigkeitsregelung.

Verfügt die elektronische Regelung über eine elektronische Auswerteschaltung, die aus bestimmten Gründen nur in der Lage ist "gleichsinnige" Flanken einer Impulsfolge auszuwerten, dann stößt man bei der Notwendigkeit, sowohl die Frequenz (Periodendauer) als auch die Pulsbreite der Signalfolge zu erfassen, auf Schwierigkeiten.

Aus der DE-OS 33 40 455 ist ein Verfahren zur Bestimmung der Impulsbreitenzeiten zweier Signale mittels eines Zählers bekannt. Die beiden Signale liegen an zwei unterschiedlichen Eingängen eines Mikrocomputers an. Zusätzlich ist noch eine externe Logikschaltung nötig, der neben dem einen auszuwertenden Signal noch ein Ausgangssignal des Mikrocomputers zugeleitet wird. Bei diesem Verfahren wird jeweils die Impulsdauer zweier Signale berechnet. Eine gleichzeitige Berechnung der Impulsdauer und der Periodendauer eines Signals ist mit diesem Verfahren nicht möglich.

Aus der DE-PS-12 81 572 ist eine Schaltungsanordnung zur Messung des Tastverhältnisses einer kurzzeitig andauernden Serie aus einer begrenzten Anzahl von Impulsen. Bei dieser Schaltungsanordnung kann von jeder Impulsserie sowohl die Perioden- und Impulsdauer als auch das Tastverhältnis zur Anzeige gebracht werden.

Die DE-OS 32 07 556 zeigt eine Anordnung zum Messen der charakteristischen Zeiten von Impulsen und Impulsserien. Hierzu werden die Spannungshöhen von einem Mikroprozessor abgefragt, abgespeichert und mit einem Vergleichswert verglichen. Die Arnordnung zeigt auch die Impulsdauer an.

Aufgabe der Erfindung

Der Erfindung liegt daher die Aufgabe zugrunde, bei einem Mikroprozessor der auf gleichsinnige Flanken reagiert, gleichzeitig Frequenz und Impulsbreite einer Impulsfolge zu erfassen und zu verarbeiten. Die Auswertung soll mit geringstem Aufwand erfolgen.

Vorteile der Erfindung

Diese Aufgabe wird erfindungsgemäß mit den Merkmalen der unabhängigen Ansprüche gelöst. Dabei wird der Vorteil erzielt, daß es gelingt, mit nur sehr wenigen Programm-Zyklus-Zeiten eine sehr hohe Genauigkeit auch in der Erfassung der Pulsbreite zu erzielen, und zwar durch verschiedene, bei einem beispielsweise nur auf negative Flanken reagierenden Mikroprozessor einsetzbare Mittel, wobei die Erfindung den weiteren Vorzug hat, daß sie auf jeden Fall einen Zähler für die Erfassung der Pulsbreite T einspart und eine wesentlich weniger komplexe Schaltung zur Erzeugung der Interrupts erforderlich macht bzw. keinen Analog-Digital-Wandler benötigt. Schließlich ist es mit vorliegender Erfindung möglich, daß sich auch bei Anwendung auf ein mit Bezug auf positive und negative Flanken auswertungsfähiges Mikroprozessorsystem die wesentliche Einsparung des zweiten Zählers ergibt.

Zeichnung

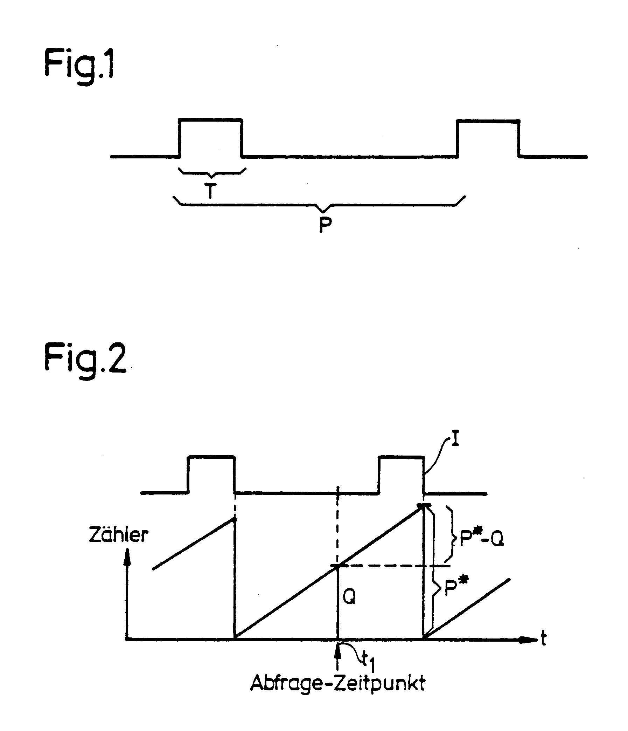

Drei Ausführungsbeispiele der Erfindung sind in der Zeichnung dargestellt und werden in der nachfolgenden Beschreibung näher erläutert. Es zeigen Fig. 1 in Form eines Diagramms eine Impulsfolge mit Information in Periodendauer und Pulsbreite (Impulsbreite) und Fig. 2, auf die Signalimpulsfolge bezogen, den zeitlichen Verlauf der Arbeitsweise des einen verwendeten Zählers zur Ermittlung sowohl der Periodendauer Signalinformation als auch der Pulsbreiten-Signalinformation.

Beschreibung der Ausführungsbeispiele

Das in Fig. 1 dargestellte Signal stellt eine Impulsfolge dar, deren Frequenz $f = 1/P$ proportional zur Fahrgeschwindigkeit v des jeweils vorzugsweise mit der elektronischen Dieselregelung (EDC) ausgerüsteten Fahrzeugs ist, um die Erfindung auf ein praktisches Anwendungsbeispiel zu beziehen. Es versteht sich, daß die Erfindung auf die Anwendung im EDC-Bereich nicht beschränkt ist.

Ferner ist die Pulsbreite T der einzelnen Impulse der Signalimpulsfolge abhängig vom Fahrzeugtyp und dem Reifenumfang und ist bei einem gegebenen Fahrzeug und festem Reifenumfang insofern konstant. Es gilt folgender Zusammenhang:

$$v = \frac{T}{P} \cdot \text{const.}$$

Die Konstante in dieser Formel ist sonst nur noch abhängig vom verwendeten Fahrgeschwindigkeitsgeber, nicht von Fahrzeug und Reifen und braucht daher nicht weiter einbezogen zu werden.

Ein Mikrorechner oder Mikroprozessor ($\mu$P) ist ein zentrales Element für die Erzeugung von Ansteuersignalen oder Stellsignalen bei elektronischen Regel- oder Steuersystemen (EDC) und verfügt üblicherweise über einen sogenannten Timer oder eine Zeitbasis, die auch als Referenzzähler RZ bezeichnet wird und dessen Wert durch einen regelmäßigen Zeittakt jeweils um einen Schritt erhöht bzw. vermindert wird. Der Referenzzähler wird als freilaufender Zähler betrieben und springt jeweils nach Erreichen eines Zählerendstandes auf seinen Anfangswert zurück und beginnt von dieser Stellung erneut in Richtung Endwert zu zählen.

Der Vorgang wiederholt sich zyklisch, wobei die Zykluszeit $T_Z$ beträgt

$$T_Z = T_C \cdot 2^n$$

mit $T_C$ = Taktperiode und n = Stellenzahl des Zählers.

Um die Zeitdauer P entsprechend Fig. 1 auszuwerten, sei dann üblicherweise, wie im übrigen auch insoweit bekannt, so vorgegangen, daß ein Zähler mit einer Schaltung zur Erzeugung eines so genannten Interrupts verwendet wird, die nur im Falle der Reaktion auf negative Flanken relativ einfach aufgebaut ist. Mit anderen Worten, der Zähler zur Bestimmung der Periodenzeit P wird bei einer ersten negativen Flanke der auszuwertenden Impulsfolge entsprechend Fig. 1 angeworfen und bei der nächsten negativen Flanke ergeht jeweils der Interrupt-Befehl, der Zählerstand entspricht dann der Periodendauer P mit der Folge, daß der Mikroprozessor den erreichten Zählerstand P abspeichert und den Zähler mit Null erneut startet. Dieser Verlauf ist auch in Fig. 2 über der Zeit dargestellt.

Um jetzt noch die Pulsbreite, also die Zeit T erfassen zu können, kann nach einer der im folgenden beschriebenen Arbeitsverfahren vorgegangen werden.

1. Innerhalb des auf dem Mikroprozessor $\mu$P ablaufenden Programms wird die Signalimpulsfolge - zusätzlich zu dem parallelen Zählerbetrieb zur Periodendauererfassung - untersucht, ob der Signalpegel der Impulsfolge zu diesem Zeitpunkt gerade hoch oder nieder (high oder low) ist. Ist zum Abfragezeitpunkt die Signalimpulsfolge gerade low (siehe Zeitpunkt t1 in Fig. 2, dann wird der zu diesem Zeitpunkt vorliegende augenblickliche Zählerstand Q, der sich also zu diesem Zeitpunkt bei der Periodendauerermittlung ergeben hat, abgespeichert.

Die nächste negative Flanke der Impulsfolge (in Fig. 2 mit I bezeichnet) führt dann zur Abspeicherung des Zählerendwerts P* als Maß für die Periodendauer. Es wird dann der Differenzwert P* - Q mit einem bisher abgespeicherten Wert B verglichen. Dieser bisher abgespeicherte Wert B ist beispielsweise bei Programm-Start auf Maximalwert gesetzt worden. Ist die Differenz P* - Q kleiner als B, dann wird jetzt anstelle von B diese Differenz P* - Q als neuer B-Wert abgespeichert. Da sich einerseits während der Fahrt die Geschwindigkeit und damit die Periodendauer P der Impulsfolge ändert und da andererseits die Abspeicherung von Q (zum jeweiligen Abfragezeitpunkt) und bei Berücksichtigung von Programm-Zyklus-Zeiten im ms-Bereich (sehr oft) erfolgt, ist gewährleistet, daß sich B bzw. die jeweils nachfolgend geänderten B-Werte dem Wert T sehr rasch bis auf hohe Genauigkeit annähern.

2. Ein weiteres Verfahren zur Erfassung des Wertes T innerhalb des auf dem Mikroprozessor $\mu$P ablaufenden Programms besteht darin, daß innerhalb eines vorgegebenen Zeitfensters von beispielsweise wenigen $\mu$s das Impulsfolgensignal daraufhin überprüft wird, ob innerhalb dieses Zeitfensters eine positive Flanke (von low nach high) auftritt. Ist dies der Fall, so wird nach Ablauf des Zeitfensters der augenblickliche Zählerstand Q abgespeichert - auch hier also wieder bezogen auf die parallel ablaufende Periodendauerermittlung. Die nächste negative Flanke führt dann zur Abspeicherung von P* und es wird dann wiederum der Differenzwert P* - Q verglichen mit einem bisher abgespeicherten Wert B, der bei Programmstart auf Maximalwert gesetzt wird. Ist P* - Q kleiner als B, dann wird der Differenzwert P* - Q als neuer B-Wert abgespeichert. Da sich während der Fahrt die Geschwindigkeit und damit P ändert, und da das Zeitfenster (bei Programm-Zyklus-Zeiten im ms-Bereich) sehr oft auftritt, ist auch hier gewährleistet, daß positive Flanken in das Zeitfenster fallen. Schon die erste in das Zeitfenster fallende Flanke genügt, um dann mit dem neuen B-Wert eine Angabe zu haben, die sich dem zu messenden T-Wert mit einer Genauigkeit entsprechend der Zeitfenster-Breite annähert, sich von diesem also nur um einige $\mu$s unterscheiden kann. Jede weitere solche Flanke kann die Genauigkeit dann nur noch weiter verbessern. Innerhalb des Zeitfensters können vom Programin darüber hinaus auch andere Funktionen bearbeitet werden, da das Signal nur am Anfang und am Ende des Zeitfensters überprüft zu werden braucht.

3. Es wird so vorgegangen, wie soeben unter Punkt 2. beschrieben mit der Ausnahme, daß während des Zeitfensters eine ständige Überwachung der Signalimpulsfolge vorgenommen und die erste registrierte positive Flanke ausgewertet wird, die dann sofort zum korrekten Wert von T führt.

Die Bestimmung des T-Werts entsprechend den Ermittlungsverfahren nach 1., 2. oder 3. ist unter Verwendung nur eines Zählers für die Periodendauerermittlung T auch dann möglich, wenn Interrupts (ausschließlich) durch positive Flanken ausgelöst werden. Dann wird mit dem gesetzten Wert B statt der Differenzwert P* - Q der Wert Q direkt verglichen bzw. beim dritten Ermittlungsverfahren als T-Wert verwendet, wobei bei den Ermittlungsverfahren nach 2. und 3. das Zeitfenster auf negative Flanken hin überwacht wird.

**Patentansprüche**

1. Verfahren zur gemeinsamen Auswertung jeweils einer Periodendauer (P) und einer Impulsbreitenzeit (T) einer Impulsfolge mit von niederem auf hohen Signalpegel ansteigenden und von hohem auf niederen Signalpegel abfallenden Flanken, insbesondere bei der Verarbeitung von Fahrgeschwindigkeitssignalen durch eine beim Betrieb von Kraftfahrzeugen eingesetzte Rechenschaltung, wobei die Periodendauer (P) mittels eines Zählers durch Auszählen von Impulsen zwischen zwei abfallenden Flanken der Impulsfolge und Speicherung des ermittelten Werts (P*) bestimmt wird, wobei zur Auswertung der Impulsbreitenzeit (T) der Impulsfolge während des auf einem Mikroprozessor ablaufenden Programms wenigstens einmal je Programmzyklus festgestellt wird, ob augenblicklich der niedere Signalpegel der Impulsfolge vorliegt, bei Vorliegen des niederen Signalpegels der momentane Inhalt (Q) des Zählers gespeichert wird, bei Auftreten der nächsten abfallenden Flanke die Differenz zwischen dem dann erreichten Zählerwert (P*) und dem gespeicherten Inhalt (Q) des Zähler gebildet und diese Differenz (P*-Q) als Impulsbreitenzeit (T) abgespeichert wird, wenn sie kleiner ist, als eine bereits abgespeicherte Impulsbreitenzeit (B).

2. Verfahren zur gemeinsamen Auswertung jeweils einer Periodendauer (P) und einer Impulsbreitenzeit (T) einer Impulsfolge mit von niederem auf hohen Signalpegel ansteigenden und von hohem auf niederen Signalpegel abfallenden Flanken, insbesondere bei der Verarbeitung von Fahrgeschwindigkeitssignalen durch eine beim Betrieb von Kraftfahrzeugen eingesetzte Rechenschaltung, wobei die Periodendauer (P) mittels eines Zählers durch Auszählen von Impulsen zwischen zwei abfallenden Flanken der Impulsfolge und Speicherung des ermittelten Werts (P*) bestimmt wird, wobei zur Auswertung der Impulsbreitenzeit (T) der Impulsfolge während des auf einem Mikroprozessor ablaufenden Programms wenigstens einmal je Programmzyklus festgestellt wird, ob während eines Zeitfensters sehr kurzer Dauer eine ansteigende Flanke vorliegt, bei Vorliegen einer ansteigenden Flanke der Inhalt (Q) des Zählers nach Ablauf des Zeitfensters gespeichert wird, bei Auftreten der nächsten abfallenden Flanke die Differenz zwischen dem dann erreichten Zählerwert (P*) und dem gespeicherten Inhalt (Q) des Zähler gebildet und diese Differenz (P*-Q) als Impulsbreitenzeit (T) abgespeichert wird, wenn sie kleiner ist, als eine bereits abgespeicherte Impulsbreitenzeit (B), wobei dieses Verfahren wiederholt wird, so daß der abgespeicherte Wert der Impulsbreitenzeit (T) dem tatsächlichen Wert mit hoher Genauigkeit angenähert wird.

3. Verfahren zur gemeinsamen Auswertung jeweils einer Periodendauer (P) und einer Impulsbreitenzeit (T) einer Impulsfolge mit von niederem auf hohen Signalpegel ansteigenden und von hohem auf niederen Signalpegel abfallenden Flanken, insbesondere bei der Verarbeitung von Fahrgeschwindigkeitssignalen durch eine beim Betrieb von Kraftfahrzeugen eingesetzte Rechenschaltung, wobei die Periodendauer (P) mittels eines Zählers durch Auszählen von Impulsen zwischen zwei abfallenden Flanken der Impulsfolge und Speicherung des ermittelten Werts (P*) bestimmt wird, wobei zur Auswertung der Impulsbreitenzeit (T) der Impulsfolge während des auf einem Mikroprozessor ablaufenden Programms wenigstens einmal je Programmzyklus, während der gesamten Dauer eines Zeitfensters sehr kurzer Dauer festgestellt wird, ob innerhalb dieses Zeitfensters eine ansteigende Flanke auftritt, bei Auftreten einer ansteigenden Flanke der momentane Inhalt (Q) des Zählers gespeichert wird, bei Auftreten der nächsten abfallenden Flanke die Differenz zwischen dem dann erreichten Zählerwert (P*) und dem gespeicherten Inhalt (Q) des Zähler gebildet und diese Differenz (P*-Q) als Impulsbreitenzeit (T) abgespeichert wird.

4. Verfahren zur gemeinsamen Auswertung jeweils einer Periodendauer (P) und einer Impulsbreitenzeit (T) einer Impulsfolge mit von niederem auf hohen Signalpegel ansteigenden und von hohem auf niederen Signalpegel abfallenden Flanken, insbesondere bei der Verarbeitung von Fahrgeschwindigkeitssignalen durch eine beim Betrieb von Kraftfahrzeugen eingesetzte Rechenschaltung, wobei die Periodendauer (P) mittels eines Zählers durch Auszählen von Impulsen zwischen zwei ansteigenden Flanken der Impulsfolge und Speicherung des ermittelten Werts (P*) ermittelt wird, wobei zur Auswertung der Impulsbreitenzeit (T) der Impulsfolge während des auf einem Mikroprozessor ablaufenden Programms wenigstens einmal je Programmzyklus festgestellt wird, ob augenblicklich der niedere Signalpegel der Impulsfolge vorliegt, bei Vorliegen des niederen Signalpegels der momentane Inhalt (Q) des Zählers als Impulsbreitenzeit (T) gespeichert wird, wenn dieser momentane Inhalt (Q) des Zählers kleiner ist, als eine bereits abgespeicherte Impulsbreitenzeit (B).

5. Verfahren zur gemeinsamen Auswertung jeweils einer Periodendauer (P) und einer Impulsbreitenzeit (T) einer Impulsfolge mit von niederem auf hohen Signalpegel ansteigenden und von hohem auf niederen Signalpegel abfallenden Flanken, insbesondere bei der Verarbeitung von Fahrgeschwindigkeitssignalen durch eine beim Betrieb von Kraftfahrzeugen eingesetzte Rechenschaltung, wobei die Periodendauer (P) mittels eines Zählers durch Auszählen von Impulsen zwischen zwei ansteigenden Flanken der Impulsfolge und Speicherung des ermittelten Werts (P*) ermittelt wird, wobei zur Auswertung der Impulsbreitenzeit (T) der Impulsfolge während des auf einem Mikroprozessor ablaufenden Programms wenigstens einmal je Programmzyklus festgestellt wird, ob innerhalb eines Zeitfensters sehr kurzer Dauer eine abfallende Flanke vorliegt, bei Vorliegen einer abfallenden Flanke der Inhalt (Q) des Zählers nach Ablauf des Zeitfensters als Impulsbreitenzeit (T) gespeichert wird, wenn der Inhalt des Zählers kleiner ist, als eine bereits abgespeicherte Impulsbreitenzeit (B), wobei dieses Verfahren wiederholt wird, so daß der abgespeicherte Wert der Impulsbreitenzeit (T) dem tatsächlichen Wert mit hoher Genauigkeit angenähert wird.

6. Verfahren zur gemeinsamen Auswertung jeweils einer Periodendauer (P) und einer Impulsbreitenzeit (T) einer Impulsfolge mit von niederem auf hohen Signalpegel ansteigenden und von hohem auf niederen Signalpegel abfallenden Flanken, insbesondere bei der Verarbeitung von Fahrgeschwindigkeitssignalen durch eine beim Betrieb von Kraftfahrzeugen eingesetzte Rechenschaltung, wobei die Periodendauer (P) mittels eines Zählers durch Auszählen von Impulsen zwischen zwei ansteigenden Flanken der Impulsfolge und Speicherung des ermittelten Werts (P*) ermittelt wird, wobei zur Auswertung der Impulsbreitenzeit (T) der Impulsfolge während des auf einem Mikroprozessor ablaufenden Programms wenigstens einmal je Programmzyklus, während der gesamten Dauer eines Zeitfensters sehr kurzer Dauer ermittelt wird, ob innerhalb dieses Zeitfensters eine abfallende Flanke auftritt, bei Auftreten einer abfallenden Flanke der momentane Inhalt (Q) des Zählers als Impulsbreitenzeit (T) gespeichert wird.

7. Das jeweilige Verfahren nach einem der Ansprüche 1 bis 6 durchführende Vorrichtung, mit Abfragemitteln, die zu jeweils vorgegebenen Zeitpunkten des auf dem Mikroprozessor ablaufenden Programms je Programm-Zyklus wenigstens einmal aktivierbar sind, mit einer Speicheranordnung, die einen erreichten Zählerstand (P*) aus der parallel ablaufenden Periodendauerermittlung übernimmt, sowie mit Vergleichsmitteln, die einen gesetzten Maximalwert für die Impulsbreitenzeit (B) mit dem zum Abfragezeitpunkt übernommenen Zählerstand (Q) oder mit dem aus dem erreichten Zählerstand (P*) und dem übernommenen Zählerstand (Q) gebildeten Differenzwert (P*-Q) vergleichen.

## Claims

1. Method for the joint evaluation of in each case a period length (P) and a pulse width time (T) of a pulse sequence with edges rising from a low to a high signal level and falling from a high to a low signal level, particularly in the processing of vehicle speed signals by an arithmetic circuit used in the operation of motor vehicles, the period length (P) being determined by means of a counter by counting out pulses between two falling edges of the pulse sequence and storing the value (P*) determined, wherein, for the evaluation of the pulse width time (T) of the pulse sequence it is determined at least once for each program cycle during the program running on a microprocessor, whether the low signal level of the pulse sequence is currently present, the instantaneous content (Q) of the counter is stored when the low signal level is present, the difference between the count (P*) then reached and the stored content (Q) of the counter is formed when the next falling edge occurs, and this difference (P*-Q) is stored as pulse width time (T) if it is smaller than a pulse width time (B) already stored.

2. Method for the joint evaluation of in each case a period length (P) and a pulse width time (T) of a pulse sequence with edges rising from a low to a high signal level and falling from a high to a low signal level, particularly during the processing of vehicle speed signals by an arithmetic circuit used in the operation of motor vehicles, the period length (P) being determined by means of a counter by counting out pulses between two falling edges of the pulse sequence and storage of the value (P) determined, wherein, for evaluating the pulse width time (T) of the pulse sequence it is determined at least once for each program cycle during the program running on a microprocessor whether a rising edge is present during a time window of very short duration, the content (Q) of the counter is stored after the time window has elapsed when a rising edge is present, the difference between the count (P*) then reached and the stored content (Q) of the counter is formed when the next falling edge occurs and this difference (P*-Q) is stored as pulse width time (T) if it is smaller than a pulse width time (B) already stored, this method being repeated so that the stored value of the pulse width time (T) is approximated with high accuracy to the actual value.

3. Method for joint evaluation of in each case a period length (P) and a pulse width time (T) of a pulse sequence with edges rising from a low to a high signal level and falling from a high to a low signal level, particularly in the processing of vehicle speed signals by an arithmetic circuit used in the operation of motor vehicles, the period length (P) being determined by means of a counter for counting out pulses between two falling edges of the pulse sequence and storage of the value (P*) determined, wherein, for evaluating the pulse width time (T) of the pulse sequence, it is determined at least once for each program cycle during the program running on a microprocessor during the entire period of a time window of very short duration whether a rising edge occurs within this time window, the instantaneous content (Q) of the counter is stored when a rising edge occurs, the difference between the count (P*) then reached and the stored content (Q) of the counter is formed when the next falling edge occurs and this difference (P*-Q) is stored as pulse width time (T).

4. Method for the joint evaluation of in each case a period length (P) and a pulse width time (T) of a pulse sequence with edges rising from a low to a high signal level and falling from a high to a low signal level, particularly in the processing of vehicle speed signals by an arithmetic circuit used in the operation of motor vehicles, the period length (P) being determined by means of a counter by counting out pulses between two rising edges of the pulse sequence and storage of the value (P*) determined, wherein, for the evaluation of the pulse width time (T) of the pulse sequence, it is determined at least once for each program cycle during the program running on a microprocessor, whether the low signal level of the pulse sequence is currently present, the instantaneous content (Q) of the counter is stored as pulse width time (T) when the low signal level is present if this instantaneous content (Q) of the counter is less than an already stored pulse width time (B).

5. Method for the joint evaluation of in each case a period length (P) and a pulse width time (T) of a pulse sequence with edges rising from a low to a high signal level and falling from a high to a low signal level, particularly in the processing of vehicle speed signals by an arithmetic circuit used in operation of motor vehicles, the period length (P) being determined by means of a counter by counting out pulses between two rising edges of the pulse sequence and storing the value (P*) determined, wherein, for evaluation of the pulse width time (T) of the pulse sequence, it is determined at least once for each program cycle during a program running on a microprocessor, whether a falling edge is present within a time window of very short duration, the content (Q) of the counter is stored as pulse width time (T) after the time window has elapsed when a falling edge is present, if the content of the counter is smaller than a pulse width time (B) already stored, this method being repeated so that the stored value of the pulse width time (T) is approximated with high accuracy to the actual value.

6. Method for the joint evaluation of in each case a period length (P) and a pulse width time (T) of a pulse sequence with edges rising from a low to a high signal level and falling from a high to a low signal level, particularly in the processing of vehicle speed signals by an arthimatic circuit used in the operation of motor vehicles, the period length (P) being determined by means of a counter by counting out pulses between two rising edges of the pulse sequence and storing the value (P*) determined, wherein, for evaluating the pulse width time (T) of the pulse sequence, it is determined at least once for each program cycle during the program running on a microprocessor, during the entire period of a time window of very short duration, whether a falling edge occurs within this time window, and the instantaneous content (Q) of the counter is stored as pulse width time (T) when a falling edge occurs.

7.  A device for carrying out the respective method according to one of Claims 1 to 6, comprising interrogation means which can be activated at least once for each program cycle at in each case predetermined times of the program running on the microprocessor, comprising a memory arrangement which accepts a count (P*) reached from the period-length determining process running in parallel, and with comparison means which compare a set maximum value for the pulse width time (B) with the count (Q) accepted at the interrogation time or with the difference value (P*-Q) formed from the count (P*) reached and the accepted count (Q).

**Revendications**

1.  Procédé pour l'exploitation commune respectivement d'une durée de période (P) et d'une largeur d'impulsion (T) d'un train d'impulsions avec des flancs montant d'un niveau de signal bas à un niveau haut et tombant d'un niveau de signal haut à un niveau bas, en particulier lors du retraitement de signaux de vitesses de véhicule par un circuit de calcul mis en service lors de la marche de véhicules à moteur, procédé dans lequel la durée de période (P) est déterminée au moyen d'un compteur en comptant les impulsions entre deux flancs tombant du train d'impulsions et en mettant en mémoire la valeur détectée (P*), procédé dans lequel pour exploiter la largeur d'impulsion (T) du train d'impulsions pendant le programme qui se déroule dans un microprocesseur, on détermine au moins une fois lors de chaque cycle de programme, si l'on a de façon instantanée le niveau de signal le plus bas, on met en mémoire lorsqu'on est en présence du niveau de signal le plus bas, le contenu momentané (Q) du compteur, on forme lorsque surviennent les flancs suivants tombants la différence entre la valeur alors obtenue (P*) du compteur et le contenu mis en mémoire (Q) du compteur et on met en mémoire cette différence (P* - Q) comme largeur d'impulsion (T), si elle est plus petite qu'une largeur d'impulsion (B) mise déjà en mémoire.

2.  Procédé pour l'exploitation commune respectivement d'une durée de période (P) et d'une largeur d'impulsion (T) d'un train d'impulsions avec des flancs montants d'un niveau de signal bas à un niveau haut et tombant d'un niveau de signal haut à un niveau bas, en particulier lors du retraitement de signaux de vitesses de véhicule par un circuit de calcul mis en service lors de la marche de véhicules à moteur, procédé dans lequel la durée de période (P) est déterminée au moyen d'un compteur en comptant les impulsions entre deux flancs tombant du train d'impulsions et en mettant en mémoire la valeur détectée (P*), procédé dans lequel pour exploiter la largeur d'impulsion (T) du train d'impulsions pendant le programme se déroulant dans un microprocesseur, on détermine au moins une fois lors de chaque cycle de programme s'il y a un flanc montant pendant une fenêtre de temps de très courte durée, on met en mémoire le contenu (Q) du compteur s'il y a un flanc montant après le passage de la fenêtre de temps, on forme lorsque survient le flanc tombant suivant la différence entre la valeur (P*) alors atteinte par le compteur et le contenu (Q) mis en mémoire du compteur et on met en mémoire cette différence (P* - Q) comme largeur d'impulsion (T), si elle est plus petite qu'une largeur d'impulsions (B) déjà mise en mémoire, ce procédé étant répété de telle sorte que la valeur mise en mémoire de la largeur d'impulsions (T) se rapproche avec une précision élevée de la valeur effective.

3.  Procédé pour l'exploitation commune respectivement d'une durée de période (P) et d'une largeur d'impulsion (T) d'un train d'impulsions avec des flancs montant d'un niveau de signal bas à un niveau haut et tombant d'un niveau de signal haut à un niveau bas, en particulier lors du retraitement de signaux de vitesses de véhicule par un circuit de calcul mis en service lors de la marche de véhicules à moteur, procédé dans lequel la durée de période (P) est déterminée au moyen d'un compteur en comptant les impulsions entre deux flancs tombant du train d'impulsions et en mettant en mémoire la valeur détectée (P*), procédé dans lequel pour exploiter la largeur d'impulsion (T) du train d'impulsions pendant le programme qui se déroule dans un microprocesseur, on détermine au moins une fois lors de chaque cycle de programme pendant toute la durée d'une fenêtre de temps de très courte durée, si à l'intérieur de cette fenêtre de temps il survient un flanc montant, on met en mémoire quand survient un flanc montant le contenu momentané (Q) du compteur, on forme lorsque surviennent les flancs montants suivants la différence entre la valeur (P*) du compteur alors atteinte et le contenu (Q) du compteur mis en mémoire et on met en mémoire cette différence (P* - Q) comme largeur d'impulsions (T).

4. Procédé pour l'exploitation commune respectivement d'une durée de période (P) et d'une largeur d'impulsion (T) d'un train d'impulsions avec des flancs montant d'un niveau de signal bas à un niveau haut et tombant d'un niveau de signal haut à un niveau bas, en particulier lors du retraitement de signaux de vitesses de véhicule par un circuit de calcul mis en service lors de la marche de véhicules à moteur, procédé dans lequel la durée de période (P) est déterminée au moyen d'un compteur en comptant les impulsions entre deux flancs montants du train d'impulsions et en mettant en mémoire la valeur détectée (P*), procédé dans lequel pour exploiter la largeur d'impulsion (T) du train d'impulsions pendant le programme se déroulant dans un microprocesseur, on détermine au moins une fois lors de chaque cycle de programme si l'on a de façon instantanée le niveau de signal bas du train d'impulsion, on met en mémoire si l'on a le niveau de signal bas le contenu momentané (Q) du compteur comme largeur d'impulsions (T), si ce contenu momentané (Q) du compteur est plus petit qu'une largeur d'impulsion (B) déjà mise en mémoire.

5. Procédé pour l'exploitation commune respectivement d'une durée de période (P) et d'une largeur d'impulsion (T) d'un train d'impulsions avec des flancs montant d'un niveau de signal bas à un niveau haut et tombant d'un niveau de signal haut à un niveau bas, en particulier lors du retraitement de signaux de vitesses de véhicule par un circuit de calcul mis en service lors de la marche de véhicules à moteur, procédé dans lequel la durée de période (P) est déterminée au moyen d'un compteur en comptant les impulsions entre deux flancs montants du train d'impulsions et en mettant en mémoire la valeur détectée (P*), procédé dans lequel pour exploiter la largeur d'impulsion (T) du train d'impulsions pendant le programme se déroulant dans un microprocesseur, on détermine au moins une fois lors de chaque cycle de programme s'il y a un flanc tombant, à l'intérieur d'une fenêtre de temps de très courte durée, s'il y a un flanc tombant on met en mémoire le contenu (Q) du compteur, après le passage de la fenêtre de temps, comme largeur d'impulsions (T) si le contenu du compteur est plus petit qu'une largeur d'impulsion (B) déjà mise en mémoire, ce procédé étant répété de telle sorte que la valeur mise en mémoire de la largeur d'impulsions (T) se rapproche avec une précision élevée de la valeur effective.

6. Procédé pour l'exploitation commune respectivement d'une durée de période (P) et d'une largeur d'impulsion (T) d'un train d'impulsions avec des flancs montant d'un niveau de signal bas à un niveau haut et tombant d'un niveau de signal haut à un niveau bas, en particulier lors du retraitement de signaux de vitesses de véhicule par un circuit de calcul mis en service lors de la marche de véhicules à moteur, procédé dans lequel la durée de période (P) est déterminée au moyen d'un compteur en comptant les impulsions entre deux flancs montants du train d'impulsions et en mettant en mémoire la valeur détectée (P*), procédé dans lequel pour exploiter la largeur d'impulsion (T) du train d'impulsions pendant le programme se déroulant dans un microprocesseur, on détermine au moins une fois lors de chaque cycle de programme s'il y a un flanc descendant pendant toute la durée d'une fenêtre de temps de très courte durée à l'intérieur de cette fenêtre de temps, on met en mémoire, quand survient un flanc descendant le contenu momentané (Q) du compteur en tant que largeur d'impulsion (T).

7. Dispositif pour la mise en oeuvre du procédé respectif selon l'une des revendications 1 à 6, avec des moyens d'interrogation, qui peuvent être activés au moins une fois aux instants respectivement prédéfinis du programme se déroulant dans le microprocesseur lors de chaque cycle de programme, avec une mise en mémoire, qui enregistre un étant (P*) atteint par le compteur à partir de la détection de la durée de période se déroulant en parallèle, ainsi qu'avec des moyens de comparaison, qui comparent une valeur maximale posée pour la largeur d'impulsion (B) avec l'état du compteur (Q) enregistré à l'instant d'interrogation ou avec la valeur différentielle (P* - Q) formée à partir de l'état du compteur (P*) atteint et de l'état du compteur (Q) enregistré.

# Fig.1

# Fig.2